(19) **Europäisches Patentamt / European Patent Office / Office européen des brevets**

(11) **EP 3 082 259 A1**

(12) **EUROPEAN PATENT APPLICATION**
published in accordance with Art. 153(4) EPC

(43) Date of publication:
**19.10.2016 Bulletin 2016/42**

(21) Application number: **14870581.7**

(22) Date of filing: **17.06.2014**

(51) Int Cl.:
***H03F 3/20*** (2006.01)     ***H03F 1/56*** (2006.01)

(86) International application number:
**PCT/CN2014/080118**

(87) International publication number:
**WO 2015/085742 (18.06.2015 Gazette 2015/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **13.12.2013 CN 201310690527**

(71) Applicant: **ZTE Corporation**
**Shenzhen, Guangdong 518057 (CN)**

(72) Inventors:
• **SHI, Shangjie**
  **Shenzhen**
  **Guangdong 518057 (CN)**
• **WANG, Xiaoping**
  **Shenzhen**
  **Guangdong 518057 (CN)**
• **ZHANG, Xiaoyi**
  **Shenzhen**
  **Guangdong 518057 (CN)**

(74) Representative: **Regimbeau**
**20, rue de Chazelles**
**75847 Paris Cedex 17 (FR)**

(54) **RADIO-FREQUENCY POWER AMPLIFIER, BASE STATION, AND IMPEDANCE ADJUSTMENT METHOD**

(57)     A radio frequency power amplifier, a base station and an impedance adjusting method are disclosed. The load impedance of the radio frequency power amplifier at a preset frequency point is adjusted through an impedance adjusting circuit arranged between an output transmission line and an output load of the radio frequency power amplifier.

Figure 1

**Description**

Technical Field

The present invention relates to a technical field of radio frequency, and particularly to a radio frequency power amplifier, a base station and an impedance adjusting method.

Background

Because a radio frequency power amplifier in a base station product is required to have features of high power and high gain, to obtain the feature of high gain, device manufacturers of the radio frequency power amplifier may perform input and output internal matching. In this way, the radio frequency power amplifier forms a resonant frequency point out of an operating frequency band, causing that devices have potential instable factors near the resonant frequency point. Under certain conditions, the instable factors may also be excited, even will cause damage to the radio frequency power amplifier under serious conditions. Therefore, it is particularly important to enhance the stability of a power amplifier.

Currently, with respect to the stability of the radio frequency power amplifier, usual methods are to adjust a matching network of input and output, add a series resistor to a gate power supply arm, add a series resonant circuit to a drain power supply arm, add a isolation between cavity bodies, etc. However, these methods are at the cost of gain, linearity, efficiency and other indexes of the radio frequency power amplifier, and have the disadvantages of being complicate to realize with poor operability.

Summary

To solve problems in an existing technology, embodiments of the present invention provide a radio frequency power amplifier, a base station and an impedance adjusting method.

To achieve above purposes, technical solutions in embodiments of the present invention are realized by that:

Embodiments of the present invention provide a radio frequency power amplifier. An impedance adjusting circuit is arranged between an output transmission line and an output load of the radio frequency power amplifier.

The impedance adjusting circuit is configured for adjusting a load impedance of the radio frequency power amplifier at a preset frequency point.

In the above solution, the impedance adjusting circuit includes a transmission line, one end of the transmission line is connected to an output end of the output transmission line of the radio frequency power amplifier, and the other end is connected to an input end of the output load of the radio frequency power amplifier.

In the above solution, a length of the transmission line is less than or equal to a half wavelength of the preset frequency point.

In the above solution, the impedance adjusting circuit includes a first component, a second component, a first capacitor and a second capacitor, wherein one end of the first component is connected to an output end of the output transmission line of the radio frequency power amplifier; the other end is connected to one end of the second component and one end of the first capacitor; the other end of the first capacitor is grounded; the other end of the second component is connected to one end of the second capacitor; and the other end of the second capacitor is grounded.

In the above solution, both of the first component and the second component include an inductor and a microstrip line.

Embodiments of the present invention also provide a base station. The base station includes any of the above radio frequency power amplifiers.

Embodiments of the present invention also provide an impedance adjusting method. The method includes:

operating an impedance adjusting circuit to adjust a load impedance of a radio frequency power amplifier at a preset frequency point, wherein the impedance adjusting circuit is arranged between an output transmission line and an output load of the radio frequency power amplifier.

In the above solution, the impedance adjusting circuit includes a transmission line. Operating the impedance adjusting circuit to adjust the load impedance at the preset frequency point includes: adjusting a length of the transmission line to adjust the load impedance of the radio frequency power amplifier at the preset frequency point.

In the above solution, adjusting the length of the transmission line includes: adjusting the length of the transmission line to be less than or equal to a half wavelength of the preset frequency point.

In the above solution, the impedance adjusting circuit includes a first component, a second component, a first capacitor and a second capacitor. Operating the impedance adjusting circuit to adjust the load impedance at the preset frequency point comprises: adjusting values of the first component, the second component, the first capacitor and the second capacitor to adjust the load impedance of the radio frequency power amplifier at the preset frequency point.

In the radio frequency power amplifier, the base station and the impedance adjusting method provided in embodiments of the present invention, an impedance adjusting circuit is arranged between an output transmission line and an output load of the radio frequency power amplifier for adjusting a load impedance of the radio frequency power amplifier at a preset frequency point. As such, an influence on a performance index of the radio frequency power amplifier within an operating frequency band is reduced while improving stability of the radio frequency power amplifier.

Description of the Drawings

In drawings (not necessarily drawn to scale), similar components can be described by similar reference signs in different figures. Similar reference signs with different letter suffixes can represent different examples of similar components. Drawings generally show various embodiments discussed herein by way of examples instead of limitations.

Figure 1 is a composition structure diagram showing a general radio frequency power amplifier.
Figure 2 is a composition structure diagram showing a radio frequency power amplifier in embodiments of the present invention.
Figure 3 is a composition structure diagram showing one radio frequency power amplifier in embodiments of the present invention.
Figure 4 is a composition structure diagram showing another radio frequency power amplifier in embodiments of the present invention.
Figure 5 is an exemplary schematic diagram showing a Smith chart corresponding to another radio frequency power amplifier in embodiments of the present invention.
Figure 6 is a composition structure diagram showing a base station which includes a radio frequency power amplifier having an impedance adjusting circuit in embodiments of the present invention.
Figure 7 is a flow diagram showing a method for realizing impedance adjustment for a radio frequency power amplifier in embodiments of the present invention.

Detailed Description

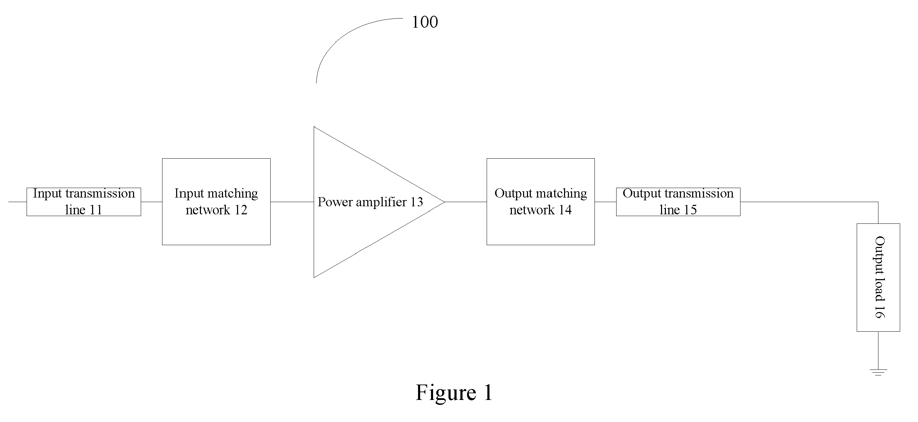

Figure 1 is a composition structure diagram showing a general radio frequency power amplifier 100. As shown in Figure 1, the radio frequency power amplifier 100 includes: an input transmission line 11, an input matching network 12, a power amplifier 13, an output matching network 14, an output transmission line 15 and an output load 16, which are connected successively. According to a basic theory of an analog circuit, the radio frequency power amplifier 100 may be equivalent to a two-port network. Moreover, a stable region and an instable region for the power amplifier can be determined through a Smith chart according to load impedance. Variance of the load impedance of the two-port network may have a direct influence on whether the radio frequency power amplifier 100 is in the stable region.

Based on this, when the radio frequency power amplifier 100 is operated out of an operating frequency band and is in the instable region of the Smith chart, to prevent generation of self-excited oscillation and enable the radio frequency power amplifier 100 to avoid the instable region of the Smith chart, improvements can be made based on a structure of the radio frequency power amplifier 100. By adjusting the load impedance of the radio frequency power amplifier 100, an influence on a performance index of the radio frequency power amplifier 100 within the operating frequency band can be reduced while enabling the radio frequency power amplifier 100 to avoid the instable region of the Smith chart.

In view of this, in embodiments of the present invention: an impedance adjusting circuit is arranged between an output transmission line and an output load of the radio frequency power amplifier, and the load impedance of the radio frequency power amplifier at a preset frequency point may be adjusted through the installed impedance adjusting circuit.

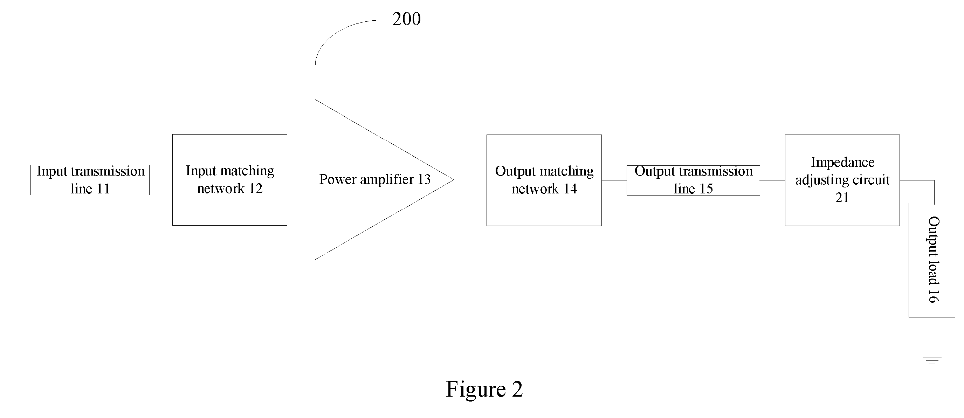

Figure 2 is a composition structure diagram showing a radio frequency power amplifier in embodiments of the present invention. As shown in Figure 2, the radio frequency power amplifier 200 having the impedance adjusting circuit in embodiments of the present invention includes: an input transmission line 11, an input matching network 12, a power amplifier 13, an output matching network 14, an output transmission line 15 and an output load 16. A key is that the radio frequency power amplifier 200 also includes: an impedance adjusting circuit 21 arranged between the output transmission line 15 and the output load 16, and the impedance adjusting circuit 21 is configured for adjusting a load impedance of the radio frequency power amplifier at a preset frequency point.

Specifically, one end of the impedance adjusting circuit 21 is connected to an output end of the output transmission line 15 of the radio frequency power amplifier 200, and the other end of the impedance adjusting circuit 21 is connected to an input end of the output load 16 of the radio frequency power amplifier 200.

At the preset frequency point, under a condition that the output matching network 14 of the radio frequency power amplifier 200 is constant, the load impedance can be changed by operating the impedance adjusting circuit 21. Thus, the radio frequency power amplifier 200 can be operated in the stable region of the Smith chart at the preset frequency point and can be stably operated. Stability of the radio frequency power amplifier 200 at the preset frequency point can thereby be fundamentally improved. The preset frequency point may be a frequency point having instability, and may be determined according to actual demands during design.

Wherein, the impedance adjusting circuit 21 can be realized through the transmission line and can also be realized through a circuit including the first component, the second component, the first capacitor and the second capacitor, achieving simple design and easy realization.

The present invention is further described below in combination with drawings of the description and specific embodiments.

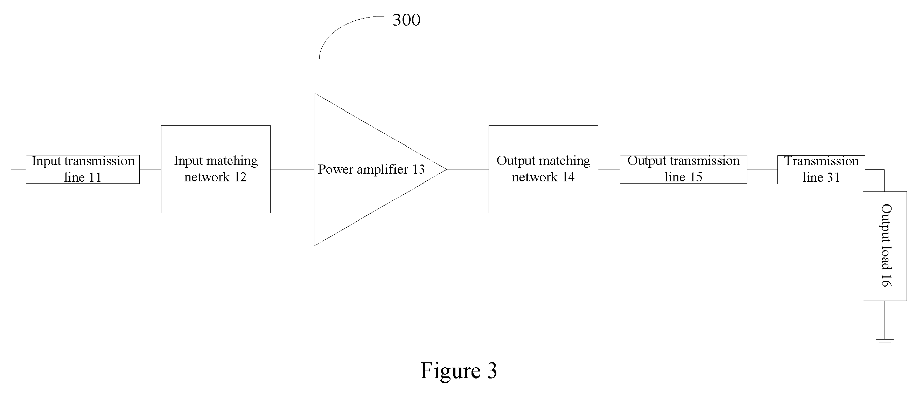

Figure 3 is a composition structure diagram showing one radio frequency power amplifier in embodiments of the present invention. As shown in Figure 3, the radio frequency power amplifier 300 having the impedance adjusting circuit in embodiments of the present invention includes: an input transmission line 11, an input matching network 12, a power amplifier 13, an output matching network 14, an output transmission line 15 and an output load 16. A key is that the radio frequency power amplifier 300 also includes: a transmission line 31 arranged between the output transmission line 15 and the output load 16. The transmission line 31 is configured for adjusting load impedance of the radio frequency power amplifier at a preset frequency point. In present embodiments, the transmission line 31 is used as a circuit for adjusting impedance.

Specifically, one end of the transmission line 31 is connected to an output end of the output transmission line 15 of the radio frequency power amplifier 300, and the other end of the transmission line 31 is connected to an input end of the output load 16 of the radio frequency power amplifier 300, wherein the transmission line 31 includes but not limited to: a microstrip line, a strip line, a suspension microstrip, a coaxial line, etc.

The load impedance of the radio frequency power amplifier 300 at the preset frequency point can be effectively adjusted by adjusting a length of the transmission line 31, wherein the length of the transmission line 31 is less than or equal to a half wavelength of the preset frequency point. For example, according to demands during designing, when the preset frequency point is 2.6 MHZ, the radio frequency power amplifier 300 is in the instable region. A length and a width of the transmission line 31 are adjusted through a section of transmission line 31 with a length of 18 percent of a wavelength and characteristic impedance of 40 ohm, so as to ensure that the length of the transmission line 31 is less than or equal to the half wavelength. As such, the transmission line 31 can change the load impedance of the radio frequency power amplifier 300 at 2.6 MHZ, so that the radio frequency power amplifier 300 is finally in the stable region of the Smith chart for stable operation. Herein, transmission lines 31 with different characteristic impedance perform different functions on adjustment of the load impedance. By selecting appropriate characteristic impedance, an influence on performance of the radio frequency power amplifier 300 within an operating frequency band due to the transmission lines 31 can be reduced while improving stability of the radio frequency power amplifier 300.

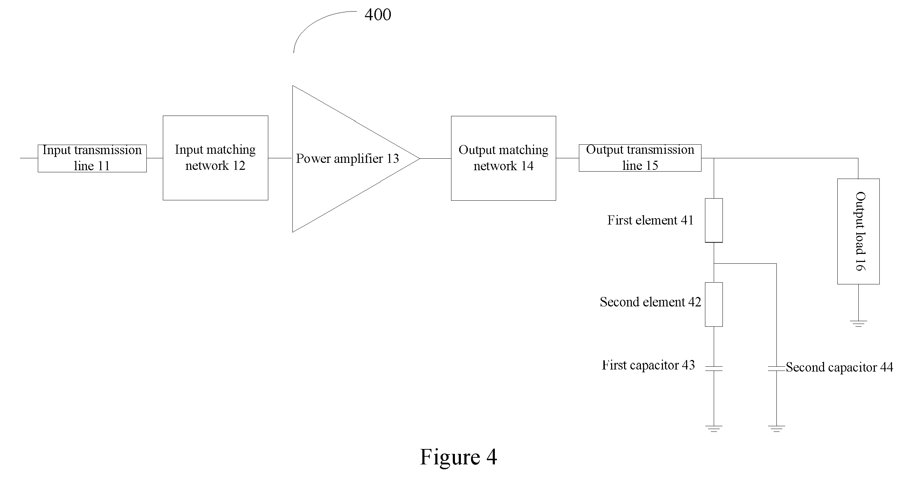

Figure 4 is a composition structure diagram showing another radio frequency power amplifier 400 in embodiments of the present invention. As shown in Figure 4, the radio frequency power amplifier 400 having the impedance adjusting circuit in embodiments of the present invention includes: an input transmission line 11, an input matching network 12, a power amplifier 13, an output matching network 14, an output transmission line 15 and an output load 16. A key is that the radio frequency power amplifier 400 also includes: a first component 41, a second component 42, a first capacitor 43 and a second capacitor 44, arranged at a connection point between the output transmission line 15 and the output load 16, configured for adjusting a load impedance of the radio frequency power amplifier at a preset frequency point. In present embodiments, the first component 41, the second component 42, the first capacitor 43 and the second capacitor 44 together form an impedance adjusting circuit.

Specifically, one end of the first component 41 is connected to an output end of the output transmission line 15 of the radio frequency power amplifier 400, and the other end of the first component 41 is connected to one end of the second component 42 and one end of the first capacitor 43; the other end of the first capacitor 43 is grounded; the other end of the second component 42 is connected to one end of the second capacitor 44; and the other end of the second capacitor 44 is grounded, wherein both of the first component 41 and the second component 42 include an inductor and a microstrip line.

The load impedance of the radio frequency power amplifier 400 at the preset frequency point can be effectively adjusted by adjusting values of the first component 41, the second component 42 and the first capacitor 43, wherein, the values of the first component 41, the second component 42 and the first capacitor 43 are determined according to the preset frequency point and a basic theory of a frequency selective network, and the second capacitor 44 is a bypass capacitor at the preset frequency point.

Specifically, when the first component 41 is a first inductor and the second component 42 is a second inductor, without considering the second inductor and the second capacitor 44, the preset frequency point $f$ is:

$$f = 1/2\pi\sqrt{L_1 C_1}$$

Wherein $L_1$ is a value of the first inductor; $C_1$ is a value of the first capacitor 43; the value of the first inductor and the value of the first capacitor 43 are calculated according to a requirement of the load impedance in the stable region of the Smith chart and the value of the preset frequency point $f$; and adjustment for the load impedance is realized by adjusting $L_1$ and $C_1$.

Considering the second inductor and the second capacitor 44, the preset frequency point $f$ is:

$$f = 1/2\pi\sqrt{L_1 L_2 C_1 /\left(L_1 + L_2\right)}$$

Wherein, $L_2$ is a value of the second inductor. After $L_2$ is introduced, to maintain the value of the preset frequency point f constant, the values of $L_1$ and $L_2$ are adjusted according to the requirement of the load impedance in the stable region of the Smith chart. $L_1$ is as large as possible. Because a bandwidth of a frequency selective characteristic of the radio frequency power amplifier 400 is relatively wide, a large influence may be generated in the operating frequency band. Increase of $L_1$ enables the radio frequency power amplifier 400 to present a high-resistance characteristic within the operating frequency band, thereby reducing an influence on the radio frequency power amplifier 400 due to adjustment for the load impedance.

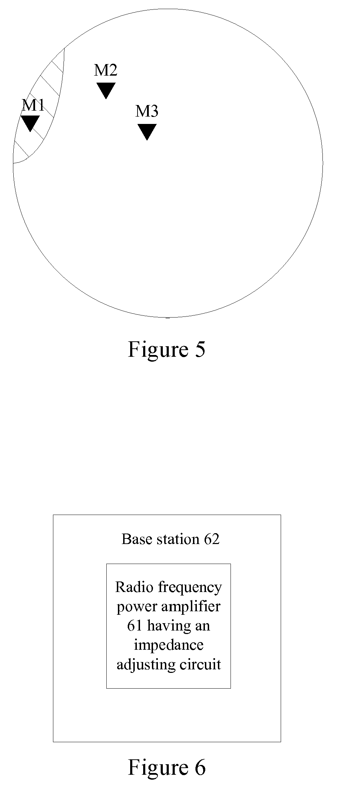

Figure 5 is an exemplary schematic diagram showing a Smith chart corresponding to another radio frequency power amplifier in embodiments of the present invention. As shown in Figure 5, for example, description is made by using stability design of a high-power radio frequency power amplifier 400 operated at 2.14 MHZ as an example. In Figure 5, a diagonal region indicates an instable region of the Smith chart corresponding to the radio frequency power amplifier 400, and in Figure 5, a blank region indicates a stable region of the Smith chart corresponding to the radio frequency power amplifier 400.

When the radio frequency power amplifier 400 is operated at 2.6 MHZ, i.e., when a preset frequency is 2.6 MHZ, as shown in Figure 5, M1 is in the instable region of the Smith chart. When the radio frequency power amplifier 400 is operated at M1 point, to avoid the instable region of the radio frequency power amplifier 400, a value of the capacitor with a resonance frequency slightly higher than 2.6 MHZ is selected, according to a series resonance characteristic of the capacitor. Herein, $C_1$=3.3pF is selected. Obtained from the preset frequency point and the basic theory of the frequency selective network, when $L_1$=0.6nH, $f$=2.6MHZ. At this moment, change of the load impedance enables the radio frequency power amplifier 400 to be operated at M2 point. As shown in Figure 5, M2 is located in the stable region of the Smith chart, and then the radio frequency power amplifier 400 can have stable operation. However, insertion loss at 2.14 MHZ is -9.41 dB, which seriously influences performance of the radio frequency power amplifier 400 within the operating frequency band.

Based on this, $L_2$ and $C_2$ are introduced. $C_2$ is a bypass capacitor of the radio frequency power amplifier 400 at 2.6 MHZ, and $C_2$ is selected as 10pF. Obtained from the preset frequency point and the basic theory of the frequency selective network, when the value of $L_2$ is smaller, the value of $L_1$ is increased. Considering a requirement of practical capacitor layout, when $L_2$= 0.3nH, if $f$=2.6MHZ is required, then $L_1$=3nH. At this moment, change of the load impedance enables the radio frequency power amplifier 400 to be operated at M3 point. As shown in Figure 5, M3 is located in the stable region of the Smith chart, and then the radio frequency power amplifier 400 can have stable operation. Moreover, insertion loss at 2.14 MHZ is -0.38 dB, which is obviously decreased compared with the insertion loss when the radio frequency power amplifier 400 is operated at M2 point, thereby reducing an influence on performance of the radio frequency power amplifier 400 within the operating frequency band.

When the first component 41 and the second component 42 are microstrip lines, corresponding values can be calculated according to an equivalent relationship between the microstrip lines and the inductor in combination with the basic theory of the microstrip lines.

Figure 6 is a composition structure diagram showing a base station which includes a radio frequency power amplifier having an impedance adjusting circuit in embodiments of the present invention. As shown in Figure 6, the base station 62 includes a radio frequency power amplifier 61 having an impedance adjusting circuit; and the radio frequency power amplifier 61 includes: an input transmission line 11, an input matching network 12, a power amplifier 13, an output matching network 14, an output transmission line 15, an output load 16 and an impedance adjusting circuit 21 arranged between the output transmission line 15 and the output load 16.

Wherein, the impedance adjusting circuit 21 can be realized through the transmission line 31 and can also be realized through a circuit including the first component 41, the second component 42, the first capacitor 43 and the second capacitor 44.

When the impedance adjusting circuit 21 is realized through the transmission line 31, as shown in Figure 3, one end of the transmission line 31 is connected to an output end of the output transmission line 15 of the radio frequency power amplifier 300, and the other end of the transmission line 31 is connected to an input end of the output load 16 of the radio frequency power amplifier 300, wherein, the transmission line 31 includes but not limited to: a microstrip line, a strip line, a suspension microstrip, a coaxial line, etc.

The load impedance of the radio frequency power amplifier 300 at the preset frequency point can be effectively adjusted by adjusting a length of the transmission line 31, wherein, a length of the transmission line 31 is less than or equal to a half wavelength of the preset frequency point.

When the impedance adjusting circuit 21 is realized through the circuit including the first component 41, the second component 42, the first capacitor 43 and the second capacitor 44, as shown in Figure 4, one end of the first component 41 is connected to an output end of the output transmission line 15 of the radio frequency power amplifier 400, the other end of the first component 41 is connected to one end of the second component 42 and one end of the first capacitor 43; the other end of the first capacitor 43 is grounded; the other end of the second component 42 is connected to one end of the second capacitor 44; and the other end of the second capacitor 44 is grounded, wherein both of the first component 41 and the second component 42 include an inductor and a microstrip line. The load impedance of the radio frequency power amplifier 400 at the preset frequency point can be effectively adjusted by adjusting values of the first component 41, the second component 42 and the first capacitor 43, wherein the values of the first component 41, the second component 42 and the first capacitor 43 are determined according to the preset frequency point and the basic theory of the frequency selective network, and the second capacitor 44 is a bypass capacitor at the preset frequency point.

Specifically, when the first component 41 is a first inductor and the second component 42 is a second inductor, without considering the second inductor and the second capacitor 44, the preset frequency point $f$ is:

$$ f = 1/2\pi\sqrt{L_1 C_1} $$

Wherein $L_1$ is a value of the first inductor; $C_1$ is a value of the first capacitor 43; the value of the first inductor and the value of the first capacitor 43 are calculated according to a requirement of the load impedance in the stable region of the Smith chart and the value of the preset frequency point $f$; and adjustment for the load impedance is realized by adjusting $L_1$ and $C_1$.

Considering the second inductor and the second capacitor 44, the preset frequency point $f$ is:

$$ f = 1/2\pi\sqrt{L_1 L_2 C_1 / (L_1 + L_2)} $$

Wherein, $L_2$ is a value of the second inductor. After $L_2$ is introduced, to maintain the value of the preset frequency point f constant, the values of $L_1$ and $L_2$ are adjusted according to the requirement of the load impedance in the stable region of the Smith chart. $L_1$ is as large as possible. Because a bandwidth of a frequency selective characteristic of the radio frequency power amplifier 400 is relatively wide, a large influence may be generated in the operating frequency band. Increase of $L_1$ enables the radio frequency power amplifier 400 to present a high-resistance characteristic within the operating frequency band, thereby reducing an influence on the radio frequency power amplifier 400 due to adjustment for the load impedance.

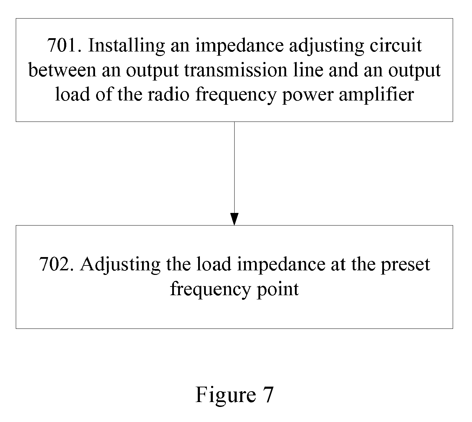

Figure 7 is a flow diagram showing a method for realizing impedance adjustment for a radio frequency power amplifier shown in Figure 3 and Figure 4 of the present invention. As shown in Figure 7, the method includes:

   Step 701: installing an impedance adjusting circuit between an output transmission line and an output load of the radio frequency power amplifier.

Herein, the radio frequency power amplifier, as shown in Figure 2, includes: an input transmission line 11, an input matching network 12, a power amplifier 13, an output matching network 14, an output transmission line 15, an output load 16 and an impedance adjusting circuit 21 arranged between the output transmission line 15 and the output load 16.

When the impedance adjusting circuit 21 is realized through the transmission line 31, as shown in Figure 3, one end of the transmission line 31 is connected to an output end of the output transmission line 15 of the radio frequency power amplifier 300, and the other end the transmission line 31 is connected to an input end of the output load 16 of the radio frequency power amplifier 300. The load impedance of the radio frequency power amplifier at the preset frequency point is adjusted by adjusting a length of the transmission line, wherein the transmission line includes but not limited to: a microstrip line, a strip line, a suspension microstrip and a coaxial line.

When the impedance adjusting circuit 21 is realized through the circuit including the first component 41, the second component 42, the first capacitor 43 and the second capacitor 44, as shown in Figure 4, the radio frequency power amplifier includes: an input transmission line 11, an input matching network 12, a power amplifier 13, an output matching network 14, an output transmission line 15, an output load 16 and a first component 41, a second component 42, a first capacitor 43 and a second capacitor 44 arranged at a connection point between the output transmission line 15 and the output load 16, configured for adjusting a load impedance of the radio frequency power amplifier at a preset frequency point.

One end of the first component 41 is connected to an output end of the output transmission line 15 of the radio frequency power amplifier 400, and the other end is connected to one end of the second component 42 and one end of the first capacitor 43; the other end of the first capacitor 43 is grounded; the other end of the second component 42 is connected to one end of the second capacitor 44; and the other end of the second capacitor 44 is grounded, wherein both of the first component 41 and the second component 42 include an inductor and a microstrip line.

Step 702: adjusting the load impedance at the preset frequency point through the installed impedance adjusting circuit.

Herein the preset frequency point is a frequency point having instability, and is determined according to actual demands during design.

When the impedance adjusting circuit 21 is realized through the transmission line 31, the load impedance of the radio frequency power amplifier 300 at the preset frequency point can be effectively adjusted by adjusting a length of the transmission line 31, wherein a length of the transmission line 31 is less than or equal to a half wavelength of the preset frequency point.

When the impedance adjusting circuit 21 is realized through the circuit including the first component 41, the second component 42, the first capacitor 43 and the second capacitor 44, the load impedance of the radio frequency power amplifier 400 at the preset frequency point can be effectively adjusted by adjusting values of the first component 41, the second component 42 and the first capacitor 43, wherein the values of the first component 41, the second component 42 and the first capacitor 43 are determined according to the preset frequency point and the basic theory of the frequency selective network, and the second capacitor 44 is a bypass capacitor at the preset frequency point.

Specifically, when the first component 41 is a first inductor and the second component 42 is a second inductor, without considering the second inductor and the second capacitor 44, the preset frequency point $f$ is:

$$f = 1 / 2\pi\sqrt{L_1 C_1}$$

Wherein $L_1$ is a value of the first inductor; $C_1$ is a value of the first capacitor 43; the value of the first inductor and the value of the first capacitor 43 are calculated according to a requirement of the load impedance in the stable region of the Smith chart and the value of the preset frequency point $f$; and adjustment for the load impedance is realized by adjusting $L_1$ and $C_1$.

Considering the second inductor and the second capacitor 44, the preset frequency point $f$ is:

$$f = 1 / 2\pi\sqrt{L_1 L_2 C_1 / \left( L_1 + L_2 \right)}$$

Wherein, $L_2$ is a value of the second inductor. After $L_2$ is introduced, to maintain the value of the preset frequency point f constant, the values of $L_1$ and $L_2$ are adjusted according to the requirement of the load impedance in the stable region of the Smith chart. $L_1$ is as large as possible. Because a bandwidth of a frequency selective characteristic of the radio frequency power amplifier 400 is relatively wide, a large influence may be generated in the operating frequency band. Increase of $L_1$ enables the radio frequency power amplifier 400 to present a high-resistance characteristic within the operating frequency band, thereby reducing an influence on the radio frequency power amplifier 400 due to adjustment for the load impedance.

When the first component 41 and the second component 42 are microstrip lines, corresponding values can be calculated according to an equivalent relationship between the microstrip lines and the inductor in combination with the basic theory of the microstrip lines.

The above only describes preferred embodiments of the present invention and is not intended to limit the protection scope of the present invention. Any modification, equivalent replacement, improvement, etc. made within the spirit and the principle of the present invention shall be contained within the protection scope of the present invention.

**Claims**

1. A radio frequency power amplifier, comprising an impedance adjusting circuit arranged between an output transmission line and an output load of the radio frequency power amplifier; wherein the impedance adjusting circuit is configured for adjusting a load impedance of the radio frequency power amplifier at a preset frequency point.

2. The radio frequency power amplifier according to claim 1, wherein the impedance adjusting circuit comprises a transmission line; and one end of the transmission line is connected to an output end of the output transmission line of the radio frequency power amplifier, and the other end of the transmission line is connected to an input end of the output load of the radio frequency power amplifier.

3. The radio frequency power amplifier according to claim 2, wherein a length of the transmission line is less than or equal to a half wavelength of the preset frequency point.

4. The radio frequency power amplifier according to claim 1, wherein the impedance adjusting circuit comprises a first component, a second component, a first capacitor and a second capacitor, and wherein one end of the first component is connected to an output end of the output transmission line of the radio frequency power amplifier; the other end of the first component is connected to one end of the second component and one end of the first capacitor; the other end of the first capacitor is grounded; the other end of the second component is connected to one end of the second capacitor; and the other end of the second capacitor is grounded.

5. The radio frequency power amplifier according to claim 4, wherein both of the first component and the second component comprise an inductor and a microstrip line.

6. A base station, comprising the radio frequency power amplifier of any one of claims 1-5.

7. An method for adjusting impedance, comprising:

operating an impedance adjusting circuit to adjust a load impedance of a radio frequency power amplifier at a preset frequency point, wherein the impedance adjusting circuit is arranged between an output transmission line and an output load of the radio frequency power amplifier.

**8.** The method according to claim 7, wherein the impedance adjusting circuit comprises a transmission line; and
operating the impedance adjusting circuit to adjust the load impedance at the preset frequency point comprises: adjusting a length of the transmission line to adjust the load impedance of the radio frequency power amplifier at the preset frequency point.

**9.** The method according to claim 8, wherein adjusting the length of the transmission line, comprises: adjusting the length of the transmission line to be less than or equal to a half wavelength of the preset frequency point.

**10.** The method according to claim 7, wherein the impedance adjusting circuit comprises a first component, a second component, a first capacitor and a second capacitor; and
operating the impedance adjusting circuit to adjust the load impedance at the preset frequency point comprises: adjusting values of the first component, the second component, the first capacitor and the second capacitor to adjust the load impedance of the radio frequency power amplifier at the preset frequency point.

Figure 1

Input transmission line 11

Input matching network 12

200

Power amplifier 13

Output matching network 14

Output transmission line 15

Impedance adjusting circuit 21

Output load 16

Figure 2

Input transmission line 11

Input matching network 12

Power amplifier 13

300

Output matching network 14

Output transmission line 15

Transmission line 31

Output load 16

Figure 3

Output load 16

Second capacitor 44

Output transmission
line 15

First element 41

Second element 42

First capacitor 43

Output matching
network 14

Power amplifier 13

400

Input matching
network 12

Input transmission
line 11

Figure 4

M2

M1

M3

Figure 5

Base station 62

Radio frequency power amplifier 61 having an impedance adjusting circuit

Figure 6

701. Installing an impedance adjusting circuit between an output transmission line and an output load of the radio frequency power amplifier

702. Adjusting the load impedance at the preset frequency point

Figure 7

# INTERNATIONAL SEARCH REPORT

| International application No. |
|---|
| **PCT/CN2014/080118** |

**A. CLASSIFICATION OF SUBJECT MATTER**

H03F 3/20 (2006.01) i; H03F 1/56 (2006.01) i

According to International Patent Classification (IPC) or to both national classification and IPC

**B. FIELDS SEARCHED**

Minimum documentation searched (classification system followed by classification symbols)

IPC: H03F

Documentation searched other than minimum documentation to the extent that such documents are included in the fields searched

Electronic data base consulted during the international search (name of data base and, where practicable, search terms used)

CNPAT; WPI; EPODOC; CNKI: output load, load, frequency point, impedance regulation, radio frequency, doherty, amplifier, rf, power amplifier, resistance, load impedance, impedance, impendance

**C. DOCUMENTS CONSIDERED TO BE RELEVANT**

| Category* | Citation of document, with indication, where appropriate, of the relevant passages | Relevant to claim No. |
|---|---|---|
| X | CN 102237852 A (NXP B.V.), 09 November 2011 (09.11.2011), description, paragraphs 0036-0044, and figures 6A, 6B, and 7-8 | 1-10 |
| A | CN 102122932 A (ZTE CORP.), 13 July 2011 (13.07.2011), the whole document | 1-10 |
| A | CN 103391057 A (COMBA TELECOM SYSTEMS (CHINA) CO., LTD.), 13 November 2013 (13.11.2013), the whole document | 1-10 |
| A | CN 102594265 A (INSTITUTE OF MICROELECTRONICS OF CHINESE ACADEMY OF SCIENCES), 18 July 2012 (18.07.2012), the whole document | 1-10 |
| A | US 2009/0085667 A1 (MOTOROLA INC.), 02 April 2009 (02.04.2009), the whole document | 1-10 |

☐ Further documents are listed in the continuation of Box C.     ☒ See patent family annex.

| *   Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 11 August 2014 (11.08.2014) | **09 September 2014 (09.09.2014)** |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer **LIU, Shuang** Telephone No.: (86-10) **82245512** |
|---|---|

Form PCT/ISA/210 (second sheet) (July 2009)

## INTERNATIONAL SEARCH REPORT
### Information on patent family members

| International application No. |
|---|
| **PCT/CN2014/080118** |

| Patent Documents referred in the Report | Publication Date | Patent Family | Publication Date |
|---|---|---|---|
| CN 102237852 A | 09 November 2011 | EP 2383883 A1 | 02 November 2011 |
| | | US 2012126890 A1 | 24 May 2012 |
| CN 102122932 A | 13 July 2011 | WO 2012097540 A1 | 26 July 2012 |
| CN 103391057 A | 13 November 2013 | None | |
| CN 102594265 A | 18 July 2012 | None | |
| US 2009/0085667 A1 | 02 April 2009 | WO 2009/045686 A2 | 09 April 2009 |

Form PCT/ISA/210 (patent family annex) (July 2009)